# EUROPÄISCHE PATENTSCHRIFT

(11) **EP 2 727 202 B1**
(45) Veröffentlichungstag und Bekanntmachung des Hinweises auf die Patenterteilung: **15.11.2017**
(21) Anmeldenummer: 12756076.1
(22) Anmeldetag: 21.06.2012
(51) Int. Cl.: H01S 5/227, H01S 5/34, H01S 5/32, H01S 5/20, H01S 5/22, H01S 5/183, H01L 33/00, H01L 21/02

(54) **ELEKTROOPTISCHES BAUELEMENT MIT STROM- UND WELLENLEITUNG DURCH SELEKTIVE OXIDATION**
ELECTRO-OPTICAL COMPONENT FEATURING CURRENT CONDUCTION AND WAVE GUIDANCE BY SELECTIVE OXIDATION
COMPOSANT ÉLECTRO-OPTIQUE À CONDUCTION DE COURANT ET GUIDAGE D'ONDE PAR OXYDATION SÉLECTIVE

(30) Priorität: 28.06.2011 DE 102011078176
(43) Veröffentlichungstag der Anmeldung: 07.05.2014
(73) Patentinhaber: Technische Universität Berlin, 10623 Berlin (DE)
(72) Erfinder: STRITTMATTER, André, 13156 Berlin (DE); SCHULZE, Jan-Hindrik, 10585 Berlin (DE); GERMANN, Tim, David, 10715 Berlin (DE)
(74) Vertreter: Fischer, Uwe
(86) Internationale Anmeldenummer: PCT/DE2012/200044
(87) Internationale Veröffentlichungsnummer: WO 2013/000460

(56) Entgegenhaltungen:
- EP-A2- 1 302 810
- US-A1- 2008 212 633
- YONG CHENG ET AL: "Lasing Characteristics of High-Performance Narrow-Stripe InGaAs-GaAs Quantum-Well Lasers Confined by AlAs Native Oxide", IEEE PHOTONICS TECHNOLOGY LETTERS, IEEE SERVICE CENTER, PISCATAWAY, NJ, US, Bd. 8, Nr. 2, 1. Februar 1996 (1996-02-01) , XP011048083, ISSN: 1041-1135
- LEE H ET AL: "Controlled ordering and positioning of InAs self-assembled quantum dots", JOURNAL OF VACUUM SCIENCE AND TECHNOLOGY: PART B, AVS / AIP, MELVILLE, NEW YORK, NY, US, Bd. 18, Nr. 4, 1. Juli 2000 (2000-07-01), Seiten 2193-2196, XP002183028, ISSN: 1071-1023, DOI: 10.1116/1.1306281

## Beschreibung

Die Erfindung bezieht sich auf ein Verfahren zum Herstellen eines elektrooptischen Bauelements, das zur Emission elektromagnetischer Strahlung geeignet ist.

Ein derartiges Verfahren ist aus der internationalen Patentanmeldung WO 2007/062625 bekannt. Bei dem vorbekannten Verfahren werden seitliche Flanken geätzt. Außerdem wird eine Stromapertur gebildet, die während des Betriebs das elektrisch angeregte Volumen definiert.

Die Druckschrift "Lasing Characteristics of High-Performance Narrow-Stripe InGaAs-GaAs Quantum-Well Lasers Confined by A-lAs Native Oxide" (Yong Cheng et al., IEEE Photonics Technology Letters, Vol. 8, No. 2, Februar 1996) offenbart einen streifenförmigen Laser und die US-Offenlegungsschrift US 2008/0212633 A1 einen vertikal emittierenden Laser. Einen Laser mit einer Vielzahl an Quantenpunkten ist in der EP-Offenlegungsschrift EP 1 302 810 A2 beschrieben. Die Druckschrift "Lateral positioning of InGaAs quantum dots using a buried stressor" (A. Strittmatter et al., Applied Physics Letters, 100, 093111, 2012) beschreibt ein Verfahren zum Erzeugen von Quantenpunkten.

Der Erfindung liegt die Aufgabe zugrunde, ein Verfahren anzugeben, mit dem sich für das elektrooptische Bauelement noch bessere Eigenschaften erreichen lassen.

Diese Aufgabe wird erfindungsgemäß durch ein Verfahren und ein Bauelement mit den Merkmalen gemäß Patentanspruch 1 und 14 gelöst. Vorteilhafte Ausgestaltungen des erfindungsgemäßen Verfahrens sind in Unteransprüchen angegeben.

Ein wesentlicher Vorteil des erfindungsgemäßen Verfahrens besteht darin, dass im Rahmen der lokalen Modifizierung der vergrabenen ersten Zwischenschicht in lateraler Richtung eine Wellenführung geschaffen wird. Durch diese laterale Wellenführung lässt sich erreichen, dass die elektrooptische Strahlung hauptsächlich oder ausschließlich im inneren Bereich des Bauelements geführt wird und insbesondere nicht (oder zumindest nicht signifikant) in den Bereich äußerer, beispielsweise geätzter Kanten, gelangen kann, so dass die Dämpfung der elektrooptischen Strahlung minimiert wird.

Ein weiterer wesentlicher Vorteil des erfindungsgemäßen Verfahrens besteht darin, dass durch das lokale Modifizieren der vergrabenen ersten Zwischenschicht neben der bereits angesprochenen Wellenführung gleichzeitig auch eine Strombündelung in demjenigen Bereich des Bauelements erreicht werden kann, in dem die erste Zwischenschicht die elektrooptische Strahlung führt. Durch den Schritt der lokalen Modifizierung lässt sich somit in vorteilhafter Weise beispielsweise sowohl eine laterale Wellenführung als auch eine elektrische Stromapertur erzeugen.

Vorzugsweise wird durch das lokale Modifizieren der ersten Zwischenschicht eine Verspannung sowohl in der ersten Zwischenschicht als auch in der darüber befindlichen zweiten Zwischenschicht hervorgerufen und eine Erhebung oberhalb eines inneren Halbleiterbereichs der ersten Zwischenschicht gebildet.

Auf der zweiten Zwischenschicht wird eine dritte Zwischenschicht aufgebracht, wobei durch die Verspannung in der ersten und zweiten Zwischenschicht auf der zweiten Zwischenschicht Nanostrukturen gebildet werden.

Die Nanostrukturen werden im Bereich der äußeren Ränder der Erhebung auf der zweiten Zwischenschicht gebildet, und zwar aufgrund der zuvor hervorgerufenen Verspannung im Bereich der äußeren Ränder der Erhebung.

Um die zur Bildung der Nanostrukturen vorteilhafte Verspannung im Bereich der äußeren Ränder der Erhebung zu erzeugen, wird es als vorteilhaft angesehen, wenn der laterale Durchmesser der Erhebung - in der Ebene der ersten Zwischenschicht gemessen - größer als 1,5 µm ist. Vorzugsweise liegt der Durchmesser im Bereich zwischen 1,5 µm und 2,5 µm. Alternativ können die Nanostrukturen auf der zweiten Zwischenschicht aufgrund der Verspannung im Mittenbereich der Erhebung gebildet werden. Um die zur Bildung der Nanostrukturen vorteilhafte Verspannung im Mittenbereich der Erhebung zu erzeugen, wird es als vorteilhaft angesehen, wenn der laterale Durchmesser der Erhebung - in der Ebene der ersten Zwischenschicht gemessen - maximal 1,5 µm beträgt.

Die dritte Zwischenschicht bildet vorzugsweise die aktive Zone des Bauelements, in der Strahlung generiert wird.

Vorzugsweise werden als Nanostrukturen Quantenpunkte oder Quantenfilme gebildet.

Als besonders vorteilhaft wird es angesehen, wenn durch die lokale Modifizierung der vergrabenen ersten Zwischenschicht in lateraler Richtung ein Brechzahlsprung symmetrisch um eine optische Achse (z. B eine Symmetrieachse) des Bauelements erzeugt wird, wodurch die laterale Wellenführung symmetrisch zur optischen Achse erfolgt. Bei dieser Ausgestaltung lässt sich durch die lokale Modifizierung der vergrabenen ersten Zwischenschicht also eine optische Zentrierung des optischen Bauelements um eine vorgegebene optische Achse, beispielsweise eine Symmetrieachse des Bauelements, hervorrufen.

Vorzugsweise wird nach dem lokalen Modifizieren der ersten Zwischenschicht auf der zweiten Zwischenschicht eine dritte Zwischenschicht epitaktisch aufgewachsen. Diese Ausgestaltung des Verfahrens ermöglicht es, dass die dritte Zwischenschicht von dem lokalen Modifikationsschritt der ersten Zwischenschicht unbeeinflusst bleibt, und insbesondere durch oder während der Modifikation der ersten Zwischenschicht nicht verändert oder verschlechtert wird.

Als besonders vorteilhaft wird es darüber hinaus angesehen, wenn durch das lokale Modifizieren der vergrabenen ersten Zwischenschicht zumindest ein Abschnitt der darüber befindlichen zweiten Zwischenschicht lokal mechanisch verspannt wird und zumindest ein Materialparameter der dritten Zwischenschicht aufgrund der lokalen Verspannung in der zweiten Zwischenschicht (zum Beispiel symmetrisch um die optische Achse des Bauelements) ortsabhängig ist. Bei dieser Ausgestaltung wird durch das lokale Modifizieren der ersten Zwischenschicht nicht nur eine laterale Wellenführung erreicht, sondern es werden darüber hinaus auch die Materialeigenschaften der darüber befindlichen dritten Zwischenschicht beeinflusst. So lässt sich durch eine lokale Verspannung beispielsweise die Bildung von Nanostrukturen (z. B. Quantendrähten, Quantenpunkten oder Quantenfilmen (fachsprachlich auch "quantum wells")) in der dritten Zwischenschicht hervorrufen oder unterstützen.

Vorzugsweise werden aufgrund der Ortsabhängigkeit eines oder mehrerer Materialparameter der dritten Zwischenschicht ein oder mehrere lokale Minima in den elektronischen Übergängen der dritten Zwischenschicht erzeugt. Das Minimum oder die Minima der elektronischen Übergänge sind vorzugsweise symmetrisch um die optische Achse des Bauelements angeordnet.

Im Zusammenhang mit der Modifikation der ersten Zwischenschicht wird es als vorteilhaft angesehen, wenn ein Abschnitt der zweiten Zwischenschicht entfernt wird und die vergrabene erste Zwischenschicht abschnittsweise freigelegt wird und die abschnittsweise freigelegte Zwischenschicht chemisch modifiziert wird, bevor die dritte Zwischenschicht auf der zweiten Zwischenschicht epitaktisch aufgewachsen wird. Das abschnittsweise Modifizieren der ersten Zwischenschicht kann beispielsweise durch Oxidieren oder Nitrieren (Nitridieren) erfolgen.

Als vorteilhaft wird es außerdem angesehen, wenn der chemisch modifizierte Abschnitt der ersten Zwischenschicht elektrisch nicht oder nur schlecht leitfähig ist und eine niedrigere Brechzahl aufweist als der unmodifizierte Abschnitt der vergrabenen ersten Zwischenschicht. Bei dieser Verfahrensvariante lässt sich in einem einzigen Verfahrensschritt sowohl eine elektrische Stromapertur als auch eine laterale Wellenführung erzwingen.

Das elektrooptische Bauelement kann bezüglich der emittierten elektromagnetischen Strahlung lateral einmodig oder lateral mehrmodig sein. Der laterale Mode bzw. die lateralen Moden der elektromagnetischen Strahlung sind vorzugsweise durch die laterale Wellenführung des unmodifizierten Bereichs der vergrabenen ersten Zwischenschicht festgelegt.

Vorzugsweise sind die Dicke der vergrabenen ersten Zwischenschicht und die laterale Abmessung des unmodifizierten Abschnitts der vergrabenen ersten Zwischenschicht derart gewählt, dass der laterale Mode oder die lateralen Moden der elektromagnetischen Strahlung durch den unmodifizierten Bereich der vergrabenen ersten Zwischenschicht definiert sind.

Vorzugsweise wird die elektromagnetische Strahlung ausschließlich, zumindest näherungsweise ausschließlich, in demjenigen Bereich der dritten Zwischenschicht erzeugt, der sich oberhalb des unmodifizierten Abschnitts der ersten Zwischenschicht befindet. Bei dieser Ausgestaltung kommt es zu einer besonders großen Überlappung zwischen der lateralen Wellenführung in der ersten Zwischenschicht und der optischen Emission (bzw. der Photonengeneration) in der dritten Zwischenschicht. Die lokale Erzeugung der elektromagnetischen Strahlung in dem Bereich oberhalb des verspannten Abschnitts der zweiten Zwischenschicht wird dabei vorzugsweise durch eine Parameteränderung innerhalb der dritten Zwischenschicht aufgrund der Verspannung in der zweiten Zwischenschicht bewirkt.

Vorzugsweise wird durch das lokale Modifizieren der ersten Zwischenschicht in der zweiten Zwischenschicht und der dritten Zwischenschicht lokal eine mechanische Verspannung induziert, durch die beim Abscheiden der dritten Zwischenschicht die Bildung von Nanostrukturen unterstützt oder hervorgerufen wird.

Die Erfindung bezieht sich darüber hinaus auf ein elektrooptisches Bauelement, das zur Emission elektromagnetischer Strahlung geeignet ist.

Erfindungsgemäß ist bezüglich eines solchen elektrooptischen Bauelements vorgesehen, dass dieses mit einer vergrabenen, lokal modifizierten ersten Zwischenschicht ausgestattet ist, bei der durch die lokale Modifizierung in lateraler Richtung ein Brechzahlsprung erzeugt wird, der eine laterale Wellenführung der elektromagnetischen Strahlung im unmodifizierten Bereich der ersten Zwischenschicht bewirkt.

Bezüglich der Vorteile des erfindungsgemäßen elektrooptischen Bauelements sei auf die obigen Ausführungen im Zusammenhang mit dem erfindungsgemäßen Verfahren verwiesen, da die Vorteile des erfindungsgemäßen Verfahrens denen des elektrooptischen Bauelements im Wesentlichen entsprechen.

Gemäß einer bevorzugten Ausgestaltung des Bauelements ist vorgesehen, dass die Dicke der vergrabenen ersten Zwischenschicht und die laterale(n) Abmessung(en) des unmodifizierten Abschnitts der vergrabenen ersten Zwischenschicht derart gewählt sind, dass der laterale Mode bzw. die lateralen Moden der elektromagnetischen Strahlung durch den unmodifizierten Bereich der vergrabenen Zwischenschicht geführt sind, auf der lokal modifizierten ersten Zwischenschicht eine zweite Zwischenschicht aufgewachsen ist, die durch die Modifizierung der vergrabenen ersten Zwischenschicht lokal verspannt ist, auf der lokal verspannten zweiten Zwischenschicht eine dritte Zwischenschicht epitaktisch aufgewachsen ist, bei der zumindest ein Materialparameter aufgrund der lokalen Verspannung in der zweiten Zwischenschicht ortsabhängig ist und die elektromagnetische Strahlung ausschließlich oder vorzugsweise in demjenigen Bereich der dritten Zwischenschicht erzeugt wird, der sich oberhalb des verspannten Abschnitts der zweiten Zwischenschicht befindet.

Die optische Achse des elektrooptischen Bauelements kann beispielsweise senkrecht auf der Oberfläche des Substrats stehen. Bei einer solchen Ausgestaltung handelt es sich um ein "vertikal emittierendes" optisches Bauelement.

Alternativ kann die optische Achse auch parallel zur Oberfläche des Trägers (oder Substrats) verlaufen: Bei einer solchen Ausgestaltung kann es sich bei dem Bauelement beispielsweise um ein kantenemittierendes Bauelement handeln. Um eine Wellenführung entlang der Oberfläche des Substrats zu erreichen, kann beispielsweise ein Rippenwellenleiter hergestellt werden, dessen Längsachse parallel zur Trägeroberfläche und/oder parallel zur optischen Achse des optoelektronischen Bauelements verläuft.

Vorzugsweise handelt es sich bei dem Substrat des elektrooptischen Bauelements um ein Galliumarsenidsubstrat.

Die Erfindung wird nachfolgend anhand von Ausführungsbeispielen näher erläutert; dabei zeigen beispielhaft:
- Figur 1: ein Ausführungsbeispiel für ein erfindungsgemäßes kantenemittierendes elektrooptisches Bauelement,
- Figuren 2-5: Herstellungsschritte, mit denen sich das Bauelement gemäß Figur 1 herstellen lässt,
- Figur 6: ein Ausführungsbeispiel für ein vertikal emittierendes elektrooptisches Bauelement,
- Figur 7: beispielhaft den Verlauf der Verspannung über der Erhebung für zwei unterschiedliche Durchmesser der Erhebung,
- Figur 8: ein Ausführungsbeispiel für ein kantenemittierendes elektrooptisches Bauelement, bei dem der Durchmesser der Erhebung derart gewählt ist, dass Nanostrukturen im Mittenbereich der Erhebung gebildet werden, und
- Figur 9: ein Ausführungsbeispiel für ein vertikal emittierendes elektrooptisches Bauelement, bei dem der Durchmesser der Erhebung derart gewählt ist, dass Nanostrukturen im Mittenbereich der Erhebung gebildet werden.

In den Figuren werden der Übersicht halber für identische oder vergleichbare Komponenten stets dieselben Bezugszeichen verwendet.

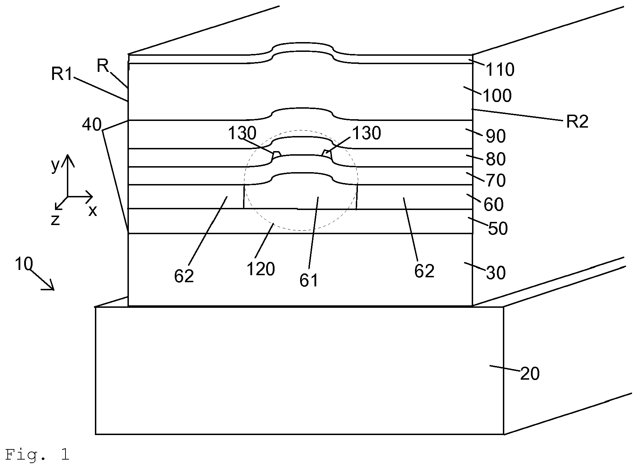

In der Figur 1 erkennt man ein elektrooptisches Bauelement 10, bei dem es sich beispielsweise um einen Laser handelt.

Das Bauelement 10 umfasst ein Substrat 20, auf dem eine untere Wellenleitermantelschicht 30 angeordnet ist. Auf dieser unteren Wellenleitermantelschicht 30 befindet sich ein Wellenleiterkern 40, der eine untere Wellenleiterkernschicht 50, eine erste Zwischenschicht 60, eine zweite Zwischenschicht 70, eine dritte Zwischenschicht 80 sowie eine obere Wellenleiterkernschicht 90 umfasst.

Das Substrat 20, die untere Wellenleitermantelschicht 30 und die untere Wellenleiterkernschicht 50 bilden einen Träger, auf dem die erste Zwischenschicht 60 aufgebracht worden ist.

Die dritte Zwischenschicht 80 bildet eine aktive Schicht, in der während des Betriebs des Bauelements 10 elektromagnetische Strahlung erzeugt wird.

Oberhalb des Wellenleiterkerns 40 befindet sich eine obere Wellenleitermantelschicht 100, auf der eine obere Kontaktschicht 110 aufgebracht ist.

Das Substrat 20 und die Schichten 30, 50, 60 (teilweise), 70, 80, 90 und 100 bestehen vorzugsweise aus halbleitendem Material. Die obere Kontaktschicht 110 kann beispielsweise aus einem hochdotierten Halbleitermaterial oder aus Metall bestehen.

Die Dotierung des Substrats 20 und der Schichten 30, 50 und 60 kann beispielsweise zu der Dotierung der Schichten 90 und 100 invers sein, um eine pn-Diodenstruktur zu bilden, mit der sich Ladungsträger in die aktive dritte Zwischenschicht 80 injizieren lassen.

Die Brechzahl der Schichten 50, 70, 80 und 90 des Wellenleiterkerns 40 ist größer als die der Wellenleitermantelschichten 30 und 100, um in vertikaler Richtung eine Wellenführung zu erreichen. Beispiele für geeignete Materialkombinationen für die Schichten 30 bis 100 sind weiter unten aufgeführt.

Bei dem Bauelement 10 gemäß Figur 1 handelt es sich um ein kantenemittierendes Bauelement. Hierzu weist das Bauelement 10 eine Rippe R auf, die sich entlang der z-Richtung erstreckt. Das Abstrahlen der elektromagnetischen Strahlung erfolgt in z-Richtung (oder entgegen der z-Richtung) an einer der beiden (oder an beiden) Endflächen der Rippe R.

Das Bauelement 10 gemäß Figur 1 lässt sich wie folgt betreiben:
Wird an die obere Kontaktschicht 110 sowie an das Substrat 20 eine elektrische Spannung angelegt, so kommt es zu einem Stromfluss durch den Wellenleiterkern 40. Aufgrund dieses Stromflusses werden in der dritten Zwischenschicht 80 Photonen erzeugt, die zu einer elektromagnetischen Strahlung entlang der z-Richtung des Bauelements 10 führen. Die Wellenausbreitung der elektromagnetischen Strahlung ist in der Figur 1 durch eine Ellipse mit dem Bezugszeichen 120 gekennzeichnet, die den Grundmode der von dem Bauelement 10 erzeugten Strahlung angibt. Der Grundmode erstreckt sich entlang der Rippenlängsrichtung entlang der z-Richtung aus der Bildebene heraus.

Die laterale Wellenführung in dem Wellenleiterkern 40 wird durch einen Brechzahlsprung in der ersten Zwischenschicht 60 hervorgerufen. Es lässt sich in der Figur 1 erkennen, dass die erste Zwischenschicht 60 einen nicht oxidierten inneren Halbleiterbereich 61 sowie einen oxidierten äußeren Bereich 62 umfasst. Die Brechzahl des inneren Halbleiterbereichs 61 liegt in dem für Halbleitermaterialien üblichen Brechzahlbereich zwischen 2 und 4, beispielsweise bei ca. 3,5. Die Brechzahl im äußeren oxidierten Bereich 62 liegt innerhalb des für Oxidmaterialien üblichen Brechzahlbereichs zwischen 1 und 2, also beispielsweise bei ca. 1,5. Durch den sehr großen Brechzahlunterschied zwischen dem inneren Halbleiterbereich 61 und dem äußeren Bereich 62 kommt es zu einer Wellenführung in lateraler Richtung, so dass die elektromagnetische Strahlung ausschließlich, zumindest näherungsweise ausschließlich, lateral im inneren Halbleiterbereich 61 geführt wird. Die elektromagnetische Strahlung kommt somit nicht (oder zumindest nicht signifikant) mit den Kanten R1 und R2, die die Rippe R nach außen begrenzen, in Kontakt.

Durch die zwei unterschiedlichen Bereiche 61 und 62 in der Zwischenschicht 60 kommt es darüber hinaus zu einer Stromfokussierung (Stromapertur) im inneren Halbleiterbereich 61, da nämlich der zwischen der oberen Kontaktschicht 110 und dem Substrat 20 fließende Strom durch den inneren Halbleiterbereich 61 fließen muss, da der äußere Bereich 62 oxidiert und damit nicht leitfähig ist.

Zur Erzeugung der elektromagnetischen Strahlung sind bei dem Ausführungsbeispiel gemäß Figur 1 in der aktiven dritten Zwischenschicht im Bereich oberhalb des inneren Halbleiterbereichs 61 der ersten Zwischenschicht 60 vorzugsweise Nanostrukturen 130 (zum Beispiel Quantendrähte, Quantenpunkte oder Quantenfilme) angeordnet, die im Falle eines Stromflusses angeregt werden und die elektromagnetische Strahlung des Bauelements erzeugen. Die Anordnung der Nanostrukturen 130 ist dabei derart gewählt, dass diese im Wesentlichen, vorzugsweise ausschließlich, oberhalb des inneren Halbleiterbereichs 61 der ersten Zwischenschicht 60 angeordnet sind bzw. dort lokal modifizierte Eigenschaften aufweisen. Bei einer solchen Anordnung der Nanostrukturen 130 wird eine besonders hohe Effizienz des Bauelements erreicht, da der gesamte durch das Bauelement 10 fließende Strom aufgrund der Stromführung durch den inneren Halbleiterbereich 61 vorzugsweise die Nanostrukturen 130 passieren muss.

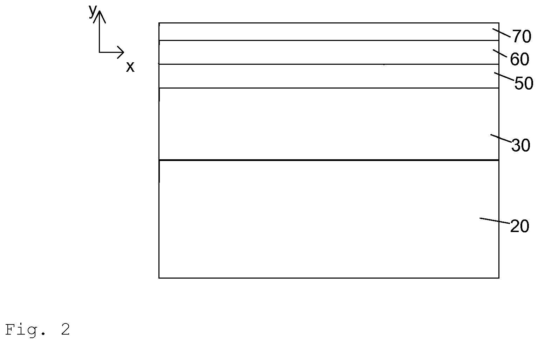

Im Zusammenhang mit den Figuren 2 bis 6 wird nun ein Ausführungsbeispiel eines Verfahrens zur Herstellung des Bauelements 10 näher erläutert.

In der Figur 2 erkennt man das Substrat 20, auf dem die untere Wellenleitermantelschicht 30 und die untere Wellenleiterkernschicht 50 aufgebracht worden sind. Das Substrat 20 und die Schichten 30 und 50 bilden einen Träger für das Aufbringen der ersten Zwischenschicht 60, auf die nachfolgend die zweite Zwischenschicht 70 aufgebracht wird.

Die genannten Schichten 30, 50, 60 und 70 können beispielsweise epitaktisch auf das Substrat 20 aufgewachsen worden sein.

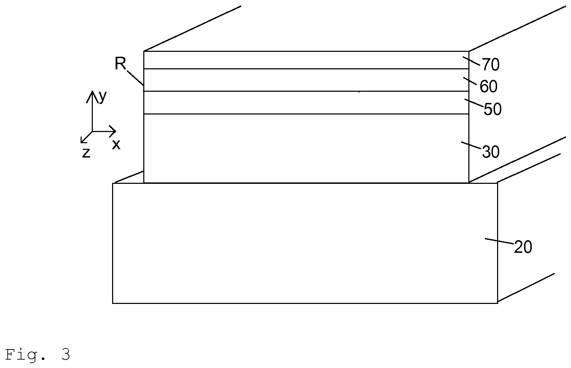

Nach dem Aufbringen der Schichten 30, 50, 60, und 70 wird in die Struktur eine Rippe R mit einer Breite von 5 - 100 µm, vorzugsweise 25 µm, geätzt, deren Längsrichtung sich entlang der z-Richtung erstreckt. Die Ätztiefe der Rippe ist so gewählt, dass diese deutlich größer als die Gesamtdicke der in weiteren Herstellungsschritten epitaktisch aufgebrachten Schichten 90, 100 und ggf. 110 ist, vorzugsweise größer 1 µm. Die Rippenstruktur ist beispielhaft in der Figur 3 gezeigt. Durch den Ätzschritt wird die erste Zwischenschicht 60 seitlich freigelegt.

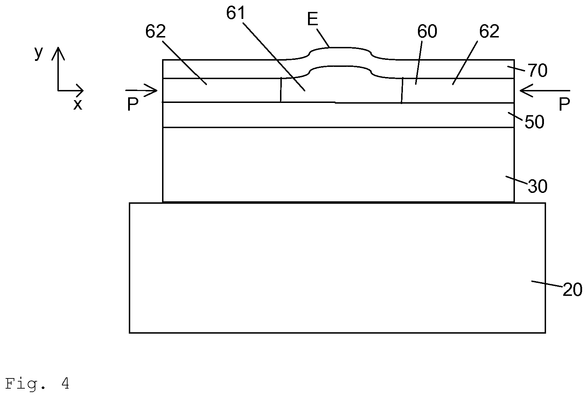

Nach dem Ätzen der Rippenstruktur R wird die erste Zwischenschicht 60 von außen oxidiert, wie durch Pfeile P in der Figur 4 gezeigt ist. Durch die Oxidation der ersten Zwischenschicht 60 werden die äußeren oxidierten Schichtbereiche 62 gebildet, die den nicht oxidierten inneren Halbleiterbereich 61 der ersten Zwischenschicht 60 einschließen.

Die Materialien der Schichten 30, 50 und 70 sind vorzugsweise aus einem anderen Material als die erste Zwischenschicht 60, so dass beim Oxidieren ausschließlich oder zumindest hauptsächlich eine Oxidation der ersten Zwischenschicht 60 erfolgt. Beispielsweise kann es sich bei dem Material der Schicht 30 um AlGaAs oder InGaP-Halbleiter, bei dem Material der Schichten 50 und 70 um AlGaAs- oder GaAs-Halbleiter und bei dem Material der ersten Zwischenschicht 60 um AlGaAs-Halbleiter handeln. Der Al-Gehalt der Zwischenschicht 60 wird in Wachstumsrichtung mindestens abschnittsweise > 80%, aber vorzugsweise zu 100%, gewählt, um eine effiziente Oxidation zu gewährleisten.

Während des Oxidationsschritts kommt es zu einer automatischen Zentrierung des inneren Halbleiterbereichs 61 relativ zu den beiden Rändern R1 und R2 der Rippe R. Durch diese automatische Justage wird erreicht, dass der Grundmode 120 (vgl. Figur 1) der elektromagnetischen Strahlung mittig zwischen den Rändern R1 und R2 der Rippe R geführt werden wird. Es wird also selbstjustierend eine Symmetrieachse des Bauelements 10 entlang der z-Achse gebildet.

In der Figur 4 lässt sich darüber hinaus erkennen, dass es aufgrund des Oxidationsschritts der ersten Zwischenschicht 60 zu einer Verspannung sowohl der ersten Zwischenschicht 60 als auch der darüber befindlichen zweiten Zwischenschicht 70 kommt. Es entsteht eine leichte Erhebung E von vorzugsweise 1 bis 10 nm Höhe im Bereich oberhalb des inneren Halbleiterbereichs 61 der ersten Zwischenschicht 60 bei Verwendung der oben genannten Materialien.

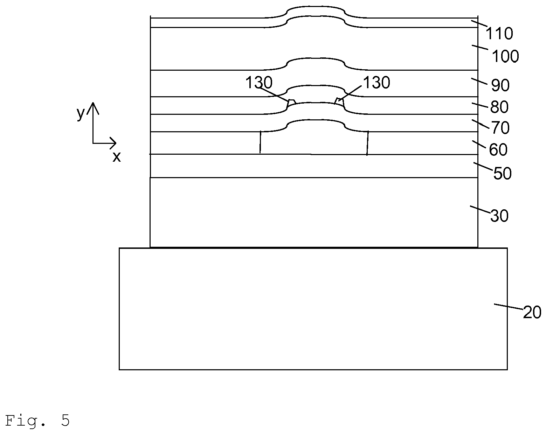

Im Rahmen weiterer Herstellungsschritte (vgl. Figur 5) werden auf die in dieser Weise verspannte zweite Zwischenschicht 70 die dritte Zwischenschicht 80 sowie die weiteren Schichten 90, 100 und 110 aufgebracht. Durch eine geeignete Materialwahl und Prozessführung beim Aufbringen der dritten Zwischenschicht 80 lässt sich erreichen, dass sich im Bereich der Erhebung E, insbesondere im Bereich der äußeren Ränder der Erhebung E, die Nanostrukturen 130 ausbilden. Die Ausbildung der Nanostrukturen 130, mit einer erreichbaren lateralen Genauigkeit von ±50 nm bis ±1 µm, beruht auf der mechanischen Verspannung innerhalb der zweiten Zwischenschicht 70, die durch die Oxidation der ersten Zwischenschicht 60 hervorgerufen worden ist.

Mit anderen Worten wird durch den Oxidationsschritt der ersten Zwischenschicht 60 nicht nur eine laterale Wellenführung für die elektromagnetische Strahlung erreicht, sondern darüber hinaus auch eine automatische Justage der Nanostrukturen 130 oberhalb des inneren Halbleiterbereichs 61 aufgrund der auftretenden mechanischen Spannungen.

Das Aufbringen der weiteren Schichten 90 und 100 erfolgt vorzugsweise ebenfalls epitaktisch. Die obere Kontaktschicht 110 kann epitaktisch abgeschieden oder auf andere Weise aufgebracht sein.

Für die Materialien der Schichten 30, 50, 60, 70, 80, 90 und 100 werden folgende Materialparameter als vorteilhaft angesehen:
- Schicht 30:: AlGaAs, Al-Gehalt zwischen 10% und 30% bzw. zwischen 65% und 80% alternativ InGaP mit einem In-Gehalt von 45% bis 52% (aber vorzugsweise 48%), n-dotiert, Schichtdicke zwischen 100 nm und 3000 nm, Dotierung zwischen 5x10¹⁷ cm⁻³ und 5x10¹⁸ cm⁻³,
- Schicht 50:: GaAs oder AlGaAs, n-dotiert, Schichtdicke zwischen 50 nm und 500 nm, Dotierung zwischen 1x10¹⁴ cm⁻³ und 1x10¹⁷ cm⁻³,
- Schicht 60:: AlGaAs, Al-Gehalt vorzugsweise 100%, kann auch einen Kompositionsgradienten oder Komposititionsstufen enthalten, n-dotiert, Schichtdicke zwischen 10 nm und 100 nm, Dotierung zwischen 5x10¹⁶ cm⁻³ und 5x10¹⁷ cm⁻³,
- Schicht 70:: GaAs, undotiert, Schichtdicke zwischen 20 nm und 500 nm,
- Schicht 80:: InGaAs oder InAs, Schichtdicke zwischen 0.2 nm und 50 nm, undotiert,
- Schicht 90:: GaAs, undotiert, Schichtdicke zwischen 50 nm und 500 nm, Dotierung zwischen 1x10¹⁴ cm⁻³ und 1x10¹⁷ cm⁻³,
- Schicht 100:: AlGaAs, Al-Gehalt zwischen 10% und 30% bzw. zwischen 65% und 80% alternativ InGaP mit einem In-Gehalt von 45% bis 52% (aber vorzugsweise 48%), p-dotiert, Schichtdicke zwischen 100 nm und 3000 nm, Dotierung zwischen 5x10¹⁷ cm⁻³ und 5x10¹⁸ cm⁻³.

Die Schichten werden vorzugsweise epitaktisch aufgewachsen. Geeignete Prozessparameter für ein Wachstumsverfahren in der Gasphase sind beispielsweise:
- Schicht 30:: Substrattemperatur 700°C, Reaktordruck 100 mbar, Wachstumsrate 1 µm/h, Ausgangsstoffe Trimethylaluminium (TMA), Trimethylgallium (TMG), Arsin (AsH₃), Verhältnis der Partialdrücke von AsH₃ zu TMG und TMA(V/III-Verhältnis) >200,
- Schicht 50:: Substrattemperatur 700°C, Reaktordruck 100 mbar, Wachstumsrate 1 µm/h, Ausgangsstoffe TMG und AsH₃, V/III-Verhältnis >100,
- Schicht 60:: Substrattemperatur 700°C, Reaktordruck 100 mbar, Wachstumsrate 1 µm/h, Ausgangsstoffe TMG, TMA und AsH₃, V/III-Verhältnis >200,
- Schicht 70:: Substrattemperatur 700°C, Reaktordruck 100 mbar, Wachstumsrate 1 µm/h, Ausgangsstoffe TMG und AsH₃, V/III-Verhältnis >100, und
- Schicht 90:: Substrattemperatur 600°C, Reaktordruck 100 mbar, Wachstumsrate 1 µm/h, Ausgangsstoffe TMG und AsH₃, V/III-Verhältnis >100.

Die Epitaxieschritte zum Aufwachsen der dritten Zwischenschicht 80 und der Nanostrukturen 130 können beispielsweise wie folgt ausgeführt werden:
- Ausheizen:: Substrattemperatur 730°C, Dauer 10 min., AsH3-Partialdruck 1 mbar,
- Schicht 80:: Substrattemperatur 600°C, Reaktordruck 100 mbar, Wachstumsrate 0.3 µm/h, Ausgangsstoffe TMG und AsH₃, V/III-Verhältnis >100, und
- Nanostrukturen 130:: Substrattemperatur 500°C, Reaktordruck 100 mbar, Wachstumsrate 0.1 µm/h, Ausgangsstoffe TMG, Trimethylindium und AsH₃, V/III-Verhältnis >5.

Für alle Schichten kann alternativ zu AsH₃ Tertiärbutylarsen (TBAs) verwendet werden. Insbesondere bei niedrigeren Wachstumstemperaturen von 450°C bis 600°C kann TBAs aufgrund seiner thermischen Eigenschaften (reduzierte Zerlegungstemperatur) vorteilhaft sein. Das Verhältnis der Partialdrücke von TBAs zu TMG und TMA (TBAs/III-Verhältnis) liegt vorzugsweise zwischen 1 und 40.

Der Oxidationsschritt zum randseitigen Oxidieren der ersten Zwischenschicht 60 kann beispielsweise wie folgt ausgeführt werden:
- Schritt 1:: Photolithografische Definition einer Ätzmaske (z.B. aus Photolack oder Siliziumnitrid) eines oder mehrerer Mesastreifen von 15-50 µm Breite.
- Schritt 2:: Nasschemische oder trockenchemische Ätzung zur Freilegung der seitlichen Streifenflächen.
- Schritt 3:: Nasschemische Entfernung der Ätzmaske.
- Schritt 4:: Oxidation der Schicht 70 in einer Stickstoff/Wasserdampf□Atmosphäre bei 350°C bis 450°C, vorzugsweise bei 420°C, Substrattemperatur. Der Reaktordruck beträgt beispielsweise ca. 50 mbar und die Flussrate für Stickstoff beispielsweise 3 Liter/min. Die Oxidationsrate wird beispielsweise auf 0.5 µm/min durch entsprechenden Fluss des Wasserdampfs eingestellt.
- Schritt 5:: Reinigung der Probe in einem Sauerstoff-Plasma.

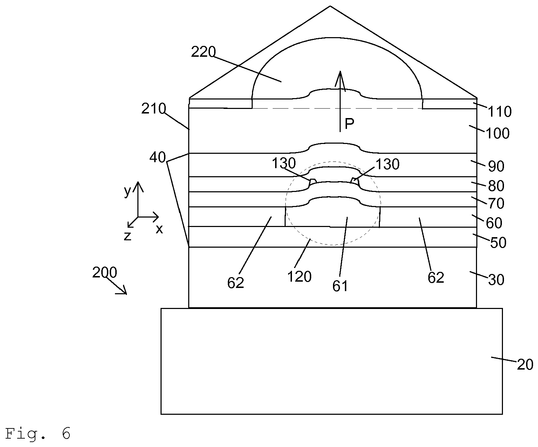

Die Figur 6 zeigt ein Ausführungsbeispiel für ein vertikal emittierendes elektrooptisches Bauelement 200. Das Bauelement weist Schichten 30 bis 110 auf, die mit denen des Bauelements 10 gemäß Figur 1 beispielsweise identisch sein können. Die Schichten 30 und 100 können jedoch auch jeweils durch einen periodischen Schichtstapel aus z. B. 5 - 30 mal (AlGaAs/GaAs) mit Schichtdicken der einzelnen Schichten zwischen z. B. 30 - 120 nm ersetzt werden, um eine vertikal reflektierende Resonatorstruktur zu erzeugen.

Im Unterschied zu dem Bauelement 10 ist bei dem Bauelement 200 anstelle einer Rippe eine Mesastruktur 210 geätzt, deren Querschnitt (von oben betrachtet) beispielsweise rund, oval oder eckig ist. Vorzugsweise ist der Querschnitt kreisförmig, so dass in Folge der Oxidation eine ringförmige Begrenzung der Schicht 61 erzeugt wird. Dadurch wird eine gleichmäßige Verteilung der Nanostrukturen beim Wachstum der dritten Zwischenschicht 80 unterstützt. Die Ätztiefe der Mesastruktur ist wiederum so gewählt, dass diese deutlich größer (> 1 µm) ist als die Gesamtdicke der in darauffolgenden Herstellungsschritten aufgebrachten Schichten.

Die Auskopplung der elektromagnetischen Strahlung erfolgt entlang der Pfeilrichtung P durch eine Öffnung 220 in der obere Kontaktschicht 110.

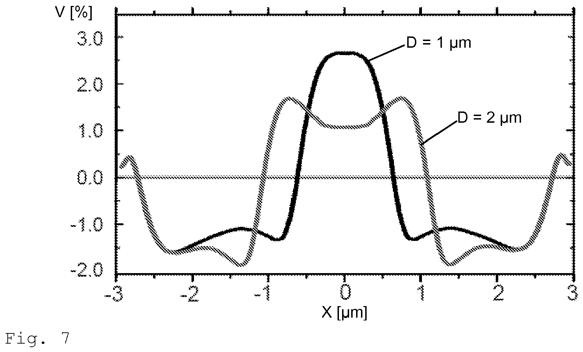

In der Figur 7 ist beispielhaft der Verlauf der Oberflächenverspannung V in Prozent auf der Oberfläche der zweiten Zwischenschicht für zwei unterschiedliche Durchmesser D der Erhebung über der jeweiligen Position X dargestellt. Es wird beispielhaft davon ausgegangen, dass sich die Mitte der Erhebung bei X = 0 µm befindet. Ein positiver Wert für die Oberflächenverspannung V beschreibt in der Figur 7 eine Zugspannung, wohingegen ein negativer Wert eine Druckspannung beschreibt.

Es lässt sich in der Figur 7 erkennen, dass bei einem großen Durchmesser D = 2 µm der Erhebung die Verspannung im Bereich der Ränder der Erhebung am größten ist und demzufolge bei einem nachfolgenden Aufbringen von Nanostrukturen diese ausschließlich oder überwiegend im Bereich der Ränder aufwachsen. Der Mittenbereich oberhalb der Erhebung bleibt bei einem großen Durchmesser somit vollständig oder nahezu vollständig frei von Nanostrukturen. Ausführungsbeispiele für Bauelemente mit Nanostrukturen im Bereich der äußeren Ränder der Erhebung wurden oben im Zusammenhang mit den Figuren 1 bis 6 erläutert.

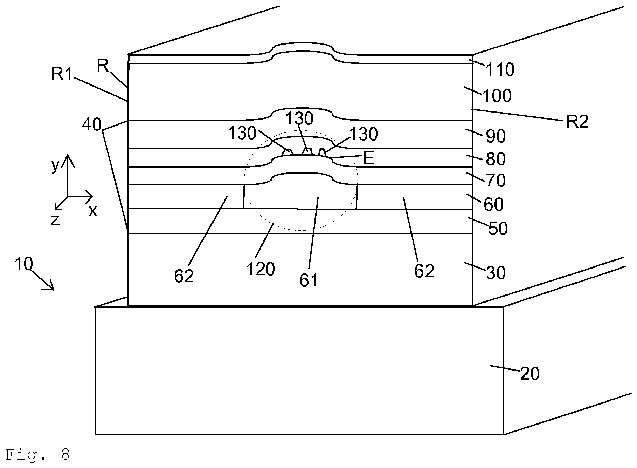

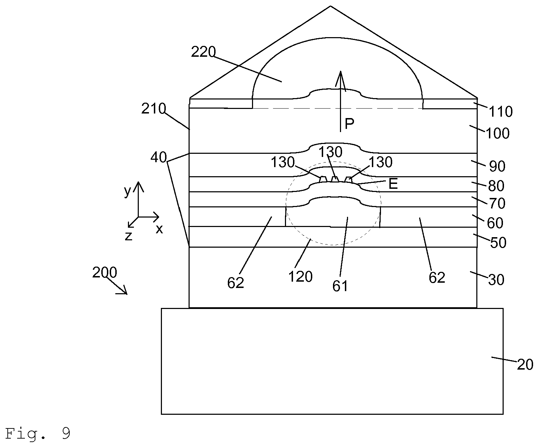

In der Figur 7 ist darüber hinaus erkennbar, dass sich bei einem kleinen Durchmesser D = 1 µm der Erhebung die Verspannung hingegen über die gesamte Erhebung ausbreitet und im Mittenbereich der Erhebung am größten ist, so dass sich bei einem nachfolgenden Aufbringen von Nanostrukturen diese besonders im Mittenbereich der Erhebung ausbilden. In den Figuren 8 und 9 sind Ausführungsbeispiele gezeigt, bei denen die Nanostrukturen aufgrund der kleinen Größe der Erhebung im Mittenbereich der Erhebung liegen.

In der Figur 8 erkennt man ein Ausführungsbeispiel für ein kantenemittierendes elektrooptisches Bauelement 10, bei dem es sich beispielsweise um einen Laser handelt. Die Nanostrukturen liegen aufgrund der kleinen Größe der Erhebung E im Mittenbereich der Erhebung. Im Übrigen entspricht das Ausführungsbeispiel gemäß Figur 8 dem Ausführungsbeispiel gemäß Figur 1.

In der Figur 9 erkennt man ein Ausführungsbeispiel für ein vertikal emittierendes elektrooptisches Bauelement 10, bei dem es sich beispielsweise um einen Laser handelt. Die Nanostrukturen liegen aufgrund der kleinen Größe der Erhebung E im Mittenbereich der Erhebung. Im Übrigen entspricht das Ausführungsbeispiel gemäß Figur 9 dem Ausführungsbeispiel gemäß Figur 6.

### Bezugszeichenliste

- 10: kantenemittierendes Bauelement
- 20: Substrat
- 30: untere Wellenleitermantelschicht
- 40: Wellenleiterkern
- 50: untere Wellenleiterkernschicht
- 60: erste Zwischenschicht
- 61: innerer Halbleiterbereich
- 62: oxidierter Schichtbereich
- 70: zweite Zwischenschicht
- 80: dritte Zwischenschicht
- 90: obere Wellenleiterkernschicht
- 100: obere Wellenleitermantelschicht
- 110: obere Kontaktschicht
- 120: Ellipse / Grundmode
- 130: Nanostruktur
- 200: vertikal emittierendes Bauelement
- 210: Mesastruktur
- 220: Öffnung
- D: Durchmesser
- E: Erhebung
- R: Rippe
- R1,R2: Kante/Rand
- P: Pfeil

## Patentansprüche

1. Verfahren zum Herstellen eines elektrooptischen Bauelements (10, 200), das zur Emission elektromagnetischer Strahlung (120) geeignet ist, wobei bei dem Verfahren
- eine erste Zwischenschicht (60) auf einem Träger aufgebracht wird,
- auf der ersten Zwischenschicht eine zweite Zwischenschicht (70) aufgebracht wird, und
- nach dem Aufbringen der zweiten Zwischenschicht eine Rippen- oder Mesastruktur unter seitlicher Freilegung der ersten Zwischenschicht (60) geätzt wird und die vergrabene und seitlich freigelegte erste Zwischenschicht randseitig von außen lokal modifiziert wird,
- wobei durch die lokale Modifizierung der vergrabenen ersten Zwischenschicht in lateraler Richtung ein Brechzahlsprung erzeugt wird, der eine laterale Wellenführung der elektromagnetischen Strahlung (120) im unmodifizierten Bereich der ersten Zwischenschicht bewirkt,
- wobei durch das lokale Modifizieren der ersten Zwischenschicht (60) eine Verspannung sowohl in der ersten Zwischenschicht (60) als auch in der darüber befindlichen zweiten Zwischenschicht (70) hervorgerufen und eine Erhebung (E) im Bereich oberhalb eines inneren Halbleiterbereichs (61) der ersten Zwischenschicht (60) gebildet wird und
- wobei auf die zweite Zwischenschicht eine dritte Zwischenschicht (80) aufgebracht wird, wobei durch die Verspannung in der ersten und zweiten Zwischenschicht auf der zweiten Zwischenschicht Nanostrukturen (130) im Bereich der äußeren Ränder der Erhebung (E) gebildet werden, und zwar aufgrund der zuvor hervorgerufenen Verspannung im Bereich der äußeren Ränder der Erhebung (E).

2. Verfahren nach Anspruch 1,
**dadurch gekennzeichnet, dass**
der laterale Durchmesser der Erhebung (E) größer als 1,5 µm ist und vorzugsweise zwischen 1,5 µm und 2,5 µm liegt.

3. Verfahren nach Anspruch 1,
**dadurch gekennzeichnet, dass**
die Nanostrukturen (130) auf der zweiten Zwischenschicht (70) im Mittenbereich der Erhebung (E) gebildet werden, und zwar aufgrund der zuvor hervorgerufenen Verspannung im Mittenbereich der Erhebung (E).

4. Verfahren nach Anspruch 3,
**dadurch gekennzeichnet, dass**
der laterale Durchmesser der Erhebung (E) maximal 1,5 µm beträgt.

5. Verfahren nach einem der voranstehenden Ansprüche,
**dadurch gekennzeichnet, dass**
die dritte Zwischenschicht (80) die aktive Zone bildet, in der Strahlung generiert wird.

6. Verfahren nach einem der voranstehenden Ansprüche,
**dadurch gekennzeichnet, dass**
als Nanostrukturen (130) Quantenpunkte oder Quantenfilme gebildet werden.

7. Verfahren nach einem der voranstehenden Ansprüche,
**dadurch gekennzeichnet, dass**
durch die lokale Modifizierung der vergrabenen ersten Zwischenschicht (60) in lateraler Richtung ein Brechzahlsprung symmetrisch um eine optische Achse des Bauelements erzeugt wird und die laterale Wellenführung symmetrisch zur optischen Achse erfolgt.

8. Verfahren nach einem der voranstehenden Ansprüche,
**dadurch gekennzeichnet, dass**
nach dem lokalen Modifizieren der ersten Zwischenschicht (60) auf der zweiten Zwischenschicht (70) eine dritte Zwischenschicht (80) epitaktisch aufgewachsen wird.

9. Verfahren nach einem der voranstehenden Ansprüche,
**dadurch gekennzeichnet, dass**
durch das lokale Modifizieren der ersten Zwischenschicht (60) in der zweiten Zwischenschicht (70) und der dritten Zwischenschicht (80) lokal eine mechanische Verspannung induziert wird, durch die beim Abscheiden der dritten Zwischenschicht (80) die Bildung von Nanostrukturen (130) unterstützt oder hervorgerufen wird.

10. Verfahren nach einem der voranstehenden Ansprüche,
**dadurch gekennzeichnet, dass**
- ein Abschnitt der zweiten Zwischenschicht (70) entfernt wird und
- die vergrabene erste Zwischenschicht (60) zumindest abschnittsweise freigelegt wird und die zumindest abschnittsweise freigelegte Zwischenschicht chemisch modifiziert wird, bevor die dritte Zwischenschicht (80) auf der zweiten Zwischenschicht (70) epitaktisch aufgewachsen wird.

11. Verfahren nach Anspruch 10,
**dadurch gekennzeichnet, dass**
der chemisch modifizierte Abschnitt (62) der ersten Zwischenschicht (60) elektrisch nicht leitfähig ist und eine niedrigere Brechzahl aufweist als der unmodifizierte Abschnitt (61) der vergrabenen ersten Zwischenschicht.

12. Verfahren nach einem der voranstehenden Ansprüche,
**dadurch gekennzeichnet, dass**
- das elektrooptische Bauelement bezüglich der emittierten elektromagnetischen Strahlung lateral einmodig oder lateral mehrmodig ist und
- der laterale Mode bzw. die lateralen Moden der elektromagnetischen Strahlung durch die laterale Wellenführung des unmodifizierten Bereichs (61) der vergrabenen ersten Zwischenschicht (60) festgelegt sind.

13. Verfahren nach einem der voranstehenden Ansprüche,
**dadurch gekennzeichnet, dass**
die elektromagnetische Strahlung ausschließlich oder überwiegend in demjenigen Bereich der dritten Zwischenschicht (80) erzeugt wird, der sich oberhalb des unmodifizierten Abschnitts (61) der ersten Zwischenschicht (60) befindet.

14. Elektrooptisches Bauelement hergestellt nach einem Verfahren nach einem der voranstehenden Ansprüche (10, 200), das zur Emission
elektromagnetischer Strahlung (120) geeignet ist, mit einer vergrabenen, lokal modifizierten ersten Zwischenschicht (60), bei der nach seitlicher Freilegung durch die lokale Modifizierung in lateraler Richtung in einer geätzten Rippen- oder Mesastruktur ein Brechzahlsprung erzeugt wurde, der eine laterale Wellenführung der elektromagnetischen Strahlung im unmodifizierten Bereich (61) der ersten Zwischenschicht (60) bewirkt,
- wobei durch das lokale Modifizieren der ersten Zwischenschicht (60) eine Verspannung sowohl in der ersten Zwischenschicht (60) als auch in einer darüber befindlichen zweiten Zwischenschicht (70) hervorgerufen und eine Erhebung (E) im Bereich oberhalb eines inneren Halbleiterbereichs (61) der ersten Zwischenschicht (60) vorhanden ist und
- wobei auf die zweite Zwischenschicht eine dritte Zwischenschicht (80) aufgebracht ist, wobei durch die Verspannung in der ersten und zweiten Zwischenschicht auf der zweiten Zwischenschicht Nanostrukturen (130) im Bereich der äußeren Ränder der Erhebung (E) vorhanden sind, und zwar aufgrund der Verspannung im Bereich der äußeren Ränder der Erhebung (E).

15. Bauelement nach Anspruch 14,
**dadurch gekennzeichnet, dass**
die Dicke der vergrabenen ersten Zwischenschicht (60) und die lateralen Abmessungen des unmodifizierten Abschnitts der vergrabenen ersten Zwischenschicht (60) derart gewählt sind, dass der laterale Mode bzw. die lateralen Moden der elektromagnetischen Strahlung durch den unmodifizierten Bereich (61) der vergrabenen Zwischenschicht geführt sind,
auf der lokal modifizierten ersten Zwischenschicht (60) eine zweite Zwischenschicht (70) aufgewachsen ist, die durch die Modifizierung der vergrabenen ersten Zwischenschicht (60) lokal verspannt ist,
auf der lokal verspannten zweiten Zwischenschicht eine dritte Zwischenschicht (80) epitaktisch aufgewachsen ist, bei der zumindest ein Materialparameter aufgrund der lokalen Verspannung in der zweiten Zwischenschicht (70) ortsabhängig ist, die elektromagnetische Strahlung ausschließlich in demjenigen Bereich der dritten Zwischenschicht (80) erzeugt wird, der sich oberhalb des unmodifizierten Abschnitts (61) der ersten Zwischenschicht (60) befindet und
die Bereiche der dritten Zwischenschicht (80), die sich oberhalb der modifizierten Abschnitte (62) der ersten Zwischenschicht (60) befinden, für die erzeugte elektromagnetische Strahlung transparent sind.

## Claims

1. Method for producing an electro-optical component (10, 200) suitable for emitting electromagnetic radiation (120), wherein in the method
- a first intermediate layer (60) is applied on a carrier,
- a second intermediate layer (70) is applied on the first intermediate layer, and
- after the second intermediate layer has been applied, a ridge or mesa structure is etched with lateral exposure of the first intermediate layer (60) and the buried and laterally exposed first intermediate layer is locally modified marginally from outside,
- wherein as a result of the local modification of the buried first intermediate layer in a lateral direction a refractive index jump is produced which brings about a lateral wave guiding of the electromagnetic radiation (120) in the unmodified region of the first intermediate layer,
- wherein the local modification of the first intermediate layer (60) causes a strain both in the first intermediate layer (60) and in the second intermediate layer (70) situated thereabove and forms an elevation (E) in the region above an inner semiconductor region (61) of the first intermediate layer (60) and
- wherein a third intermediate layer (80) is applied to the second intermediate layer, wherein nanostructures (130) are formed on the second intermediate layer in the region of the outer edges of the elevation (E) as a result of the strain in the first and second intermediate layers, to be precise on account of the strain caused previously in the region of the outer edges of the elevation (E).

2. Method according to Claim 1,
**characterized in that**
the lateral diameter of the elevation (E) is greater than 1.5 µm and preferably lies between 1.5 µm and 2.5 µm.

3. Method according to Claim 1,
**characterized in that**
the nanostructures (130) are formed on the second intermediate layer (70) in the central region of the elevation (E), to be precise on account of the strain caused previously in the central region of the elevation (E).

4. Method according to Claim 3,
**characterized in that**
the lateral diameter of the elevation (E) is a maximum of 1.5 µm.

5. Method according to any of the preceding claims,
**characterized in that**
the third intermediate layer (80) forms the active zone in which radiation is generated.

6. Method according to any of the preceding claims,
**characterized in that**
quantum dots or quantum films are formed as nanostructures (130).

7. Method according to any of the preceding claims,
**characterized in that**
as a result of the local modification of the buried first intermediate layer (60) in a lateral direction a refractive index jump is produced symmetrically about an optical axis of the component and the lateral waveguiding is effected symmetrically with respect to the optical axis.

8. Method according to any of the preceding claims,
**characterized in that**
a third intermediate layer (80) is grown epitaxially on the second intermediate layer (70) after the local modification of the first intermediate layer (60).

9. Method according to any of the preceding claims,
**characterized in that**
a mechanical strain is locally induced in the second intermediate layer (70) and the third intermediate layer (80) as a result of the local modification of the first intermediate layer (60), said mechanical strain supporting or causing the formation of nanostructures (130) during the deposition of the third intermediate layer (80).

10. Method according to any of the preceding claims,
**characterized in that**
- a section of the second intermediate layer (70) is removed and
- the buried first intermediate layer (60) is exposed at least in sections and the intermediate layer exposed at least in sections is chemically modified before the third intermediate layer (80) is grown epitaxially on the second intermediate layer (70).

11. Method according to Claim 10,
**characterized in that**
the chemically modified section (62) of the first intermediate layer (60) is electrically nonconductive and has a lower refractive index than the unmodified section (61) of the buried first intermediate layer.

12. Method according to any of the preceding claims,
**characterized in that**
- the electro-optical component is laterally monomodal or laterally multimodal with regard to the emitted electromagnetic radiation, and
- the lateral mode or the lateral modes of the electromagnetic radiation is/are defined by the lateral waveguiding of the unmodified region (61) of the buried first intermediate layer (60).

13. Method according to any of the preceding claims,
**characterized in that**
the electromagnetic radiation is generated exclusively or predominantly **in that** region of the third intermediate layer (80) which is situated above the unmodified section (61) of the first intermediate layer (60).

14. Electro-optical component (10, 200) produced according to a method according to any of the preceding claims suitable for emitting electromagnetic radiation (120), comprising a buried, locally modified first intermediate layer (60), in which after lateral exposure as a result of the local modification in a lateral direction in an etched ridge or mesa structure a refractive index jump was produced which brings about a lateral waveguiding of the electromagnetic radiation in the unmodified region (61) of the first intermediate layer (60),
- wherein the local modification of the first intermediate layer (60) causes a strain both in the first intermediate layer (60) and in a second intermediate layer (70) situated thereabove and results in an elevation (E) in the region above an inner semiconductor region (61) of the first intermediate layer (60) and
- wherein a third intermediate layer (80) is applied to the second intermediate layer, wherein nanostructures (130) are present on the second intermediate layer in the region of the outer edges of the elevation (E) as a result of the strain in the first and second intermediate layers, to be precise on account of the strain in the region of the outer edges of the elevation (E).

15. Component according to Claim 14,
**characterized in that**
the thickness of the buried first intermediate layer (60) and the lateral dimensions of the unmodified section of the buried first intermediate layer (60) are chosen in such a way that the lateral mode or the lateral modes of the electromagnetic radiation is/are guided by the unmodified region (61) of the buried intermediate layer,
a second intermediate layer (70) is grown on the locally modified first intermediate layer (60) and is locally strained as a result of the modification of the buried first intermediate layer (60),
a third intermediate layer (80) is grown epitaxially on the locally strained second intermediate layer, in which third intermediate layer at least one material parameter is location-dependent on account of the local strain in the second intermediate layer (70),
the electromagnetic radiation is generated exclusively in that region of the third intermediate layer (80) which is situated above the unmodified section (61) of the first intermediate layer (60), and
the regions of the third intermediate layer (80) which are situated above the modified sections (62) of the first intermediate layer (60) are transparent to the electromagnetic radiation generated.

## Revendications

1. Procédé de fabrication d'un composant électro-optique (10, 200) convenant pour émettre un rayonnement électromagnétique (120), et dans ce procédé :
une première couche intermédiaire (60) est appliquée sur un support,
une deuxième couche intermédiaire (70) est appliquée sur la première couche intermédiaire,
après l'application de la deuxième couche intermédiaire, une structure en nervures ou en mésa est gravée en libérant latéralement la première couche intermédiaire (60) et la première couche intermédiaire gravée et libérée latéralement est modifiée localement sur son bord depuis l'extérieur,
la modification locale de la première couche intermédiaire gravée formant dans la direction latérale un saut d'indice de réfraction qui a pour effet un guidage latéral de l'onde du rayonnement électromagnétique (120) dans la partie non modifiée de la première couche intermédiaire,
la modification locale de la première couche intermédiaire (60) provoquant une contrainte à la fois dans la première couche intermédiaire (60) et dans la deuxième couche intermédiaire (70) située au-dessus d'elle, un rehaussement (E) étant formé dans la partie située au-dessus d'une partie intérieure semiconductrice (61) de la première couche intermédiaire (60),
une troisième couche intermédiaire (80) étant appliquée sur la deuxième couche intermédiaire et la contrainte formée dans la première et dans la deuxième couche intermédiaire formant sur la deuxième couche intermédiaire des nanostructures (130) au niveau des bords extérieurs du rehaussement (E), du fait de la contrainte provoquée précédemment au niveau des bords extérieurs du rehaussement (E).

2. Procédé selon la revendication 1, **caractérisé en ce que** le diamètre latéral de rehaussement (E) est supérieur à 1,5 µm et de préférence compris entre 1,5 µm et 2,5 µm.

3. Procédé selon la revendication 1, **caractérisé en ce que** les nanostructures (130) sont formées sur la deuxième couche intermédiaire (170) dans la partie centrale du rehaussement (E) du fait de la contrainte provoquée précédemment dans la partie centrale du rehaussement (E).

4. Procédé selon la revendication 3, **caractérisé en ce que** le diamètre latéral de rehaussement (E) est d'au moins 1,5 µm.

5. Procédé selon l'une des revendications précédentes, **caractérisé en ce que** la troisième couche intermédiaire (80) forme la zone active dans laquelle le rayonnement est produit.

6. Procédé selon l'une des revendications précédentes, **caractérisé en ce que** les nanostructures (130) formées sont des points quantiques ou des films quantiques.

7. Procédé selon l'une des revendications précédentes, **caractérisé en ce que** par la modification locale de la première couche intermédiaire (60) gravée, un saut d'indice de réfraction est formé dans la direction latérale symétriquement autour d'un axe optique du composant, le guidage latéral de l'onde s'effectuant symétriquement par rapport à l'axe optique.

8. Procédé selon l'une des revendications précédentes, **caractérisé en ce qu'**après la modification locale de la première couche intermédiaire (60), une troisième couche intermédiaire (80) est formée par épitaxie sur la deuxième couche intermédiaire (70).

9. Procédé selon l'une des revendications précédentes, **caractérisé en ce que** par la modification locale de la première couche intermédiaire (60), une contrainte mécanique est induite localement dans la deuxième couche intermédiaire (70) et dans la troisième couche intermédiaire (80), la formation de nanostructures (130) étant soutenue ou provoquée lors du dépôt de la troisième couche intermédiaire (80).

10. Procédé selon l'une des revendications précédentes, **caractérisé en ce qu'**une partie de la deuxième couche intermédiaire (70) est enlevée et **en ce que** au moins certaines parties de la première couche intermédiaire (60) gravée sont libérées et la ou les parties libérées de la couche intermédiaire sont modifiées chimiquement avant la croissant par épitaxie de la troisième couche intermédiaire (80) sur la deuxième couche intermédiaire (70).

11. Procédé selon la revendication 10, **caractérisé en ce que** la partie chimiquement modifiée (62) de la première couche intermédiaire (60) n'est pas électriquement conductrice et présente un indice de réfraction plus bas que la partie non modifiée (61) de la première couche intermédiaire gravée.

12. Procédé selon l'une des revendications précédentes, **caractérisé en ce que**
dans la direction latérale, le composant électro-optique est unimodal multimodal par rapport au rayonnement électromagnétique émis et
**en ce que** le mode latéral et/ou les modes latéraux du rayonnement électromagnétique sont définis par le guidage latéral de l'onde par la partie non modifiée (61) de la première couche intermédiaire (60) gravée.

13. Procédé selon l'une des revendications précédentes, **caractérisé en ce que** le rayonnement électromagnétique est formé exclusivement ou principalement dans la partie de la troisième couche intermédiaire (80) qui est située au-dessus de la partie non modifiée (61) de la première couche intermédiaire (60).

14. Composant électro-optique (10, 200) fabriqué par un procédé selon l'une des revendications précédentes, et convenant pour une émettre un rayonnement électromagnétique (120), présentant une première couche intermédiaire (60) gravée et modifiée localement, dans laquelle après libération latérale, un saut d'indice de réfraction a été formé par une modification locale dans la direction latérale d'une structure gravée en nervures ou en mésa, ce saut ayant pour effet un guidage latéral de l'onde du rayonnement électromagnétique dans la partie non modifiée (61) de la première couche intermédiaire (60),
la modification locale de la première couche intermédiaire (60) provoquant une contrainte à la fois dans la première couche intermédiaire (60) et dans la deuxième couche intermédiaire (70) située au-dessus d'elle, un rehaussement (E) étant formé dans la partie située au-dessus d'une partie intérieure semiconductrice (61) de la première couche intermédiaire (60),
une troisième couche intermédiaire (80) étant appliquée sur la deuxième couche intermédiaire et la contrainte formée dans la première et dans la deuxième couche intermédiaire formant sur la deuxième couche intermédiaire des nanostructures (130) au niveau des bords extérieurs du rehaussement (E), du fait de la contrainte provoquée précédemment au niveau des bords extérieurs du rehaussement (E).

15. Composant selon la revendication 14, **caractérisé en ce que** l'épaisseur de la première couche intermédiaire (60) gravée et les dimensions latérales de la partie non modifiée de la première couche intermédiaire (60) gravée sont sélectionnées de telle sorte que le mode latéral ou les modes latéraux du rayonnement électromagnétique sont guidés par la partie non modifiée (60) de la couche intermédiaire gravée,
**en ce que** sur la première couche intermédiaire (60) modifiée localement, une deuxième couche intermédiaire (60) est formée et est contrainte localement par la modification de la première couche intermédiaire (60) gravée,
**en ce qu'**une troisième couche intermédiaire (80) est formée par épitaxie sur la deuxième couche intermédiaire contrainte localement, au moins un paramètre matériel dépendant de la contrainte locale formée dans la deuxième couche intermédiaire (70), le rayonnement électromagnétique étant formé exclusivement dans la partie de la troisième couche intermédiaire (80) qui se situe au-dessus de la partie non modifiée (60) de la première couche intermédiaire (60) et
**en ce que** les parties de la troisième couche intermédiaire (80) qui se situent au-dessus des parties modifiées (62) de la première couche intermédiaire (60) sont transparentes vis-à-vis du rayonnement électromagnétique formé.
